(19) Europäisches Patentamt
European Patent Office
Office européen des brevets

(11) EP 1 370 003 A1

# (12) EUROPEAN PATENT APPLICATION

(43) Date of publication:
**10.12.2003 Bulletin 2003/50**

(51) Int Cl.[7]: **H03M 13/15**

(21) Application number: **02090207.8**

(22) Date of filing: **07.06.2002**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **DEUTSCHE THOMSON-BRANDT GMBH**
**78048 Villingen-Schwenningen (DE)**

(72) Inventor: **Kravtchenko, Alexander**
**78056 Schwenningen (DE)**

## (54) Reed-Solomon Decoder

(57) The invention relates to a Reed-Solomon decoder comprising:

- means for calculation of a syndrome polynomial $\boldsymbol{S}(\boldsymbol{x})$ and an erasure locator polynomial $\Gamma(\boldsymbol{x})$,
- means for calculating a modified syndrome polynomial $\boldsymbol{T}(\boldsymbol{x})=\boldsymbol{S}(\boldsymbol{x})\Gamma(\boldsymbol{x})\mathbf{mod2}\boldsymbol{t}$, where $\boldsymbol{t}$ is the symbol-error correcting capability of the Reed-Solomon code,
- means for performing Euclid's algorithm to calculate and error locator polynomial $\Delta(\boldsymbol{x})$ and an error evaluator polynomial $\Omega(\boldsymbol{x})$,
- means for computing a second error / erasure locator polynomial $\Psi(\boldsymbol{x})=\Delta(\boldsymbol{x})\Gamma(\boldsymbol{x})$,
- means for performing a parallel Chien search,
- means for serial computation of the error magnitudes according for Forney's equation.

The invention decreases the number of cycles needed to compute the error locations and the error values and at the same time requires hardware of relatively low complexity only.

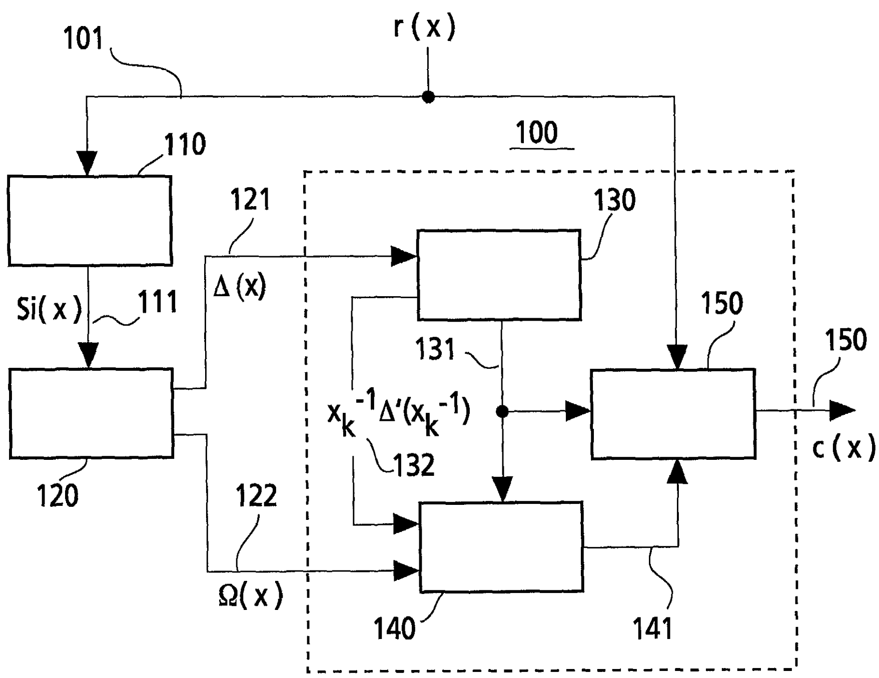


Fig.1



Printed by Jouve, 75001 PARIS (FR)

## Description

The invention pertains generally to error detection/correction and more particularly to systems and method used in Reed-Solomon decoders.

### Background

A commonly used error correcting technique is a Reed-Solomon error correcting code. Using Reed-Solomon (RS) terminology, fixed-length (n) codewords are transmitted, each codeword comprising k information symbols and n-k appended error correcting (parity) symbols. Each symbol comprises s bits. An RS decoder can correct up to (n-k) /2 symbols that contain errors in a codeword.

Because each of these correctable symbols may contain multiple bit-errors, the RS encoding technique is particularly well suited for burst errors that affect multiple contiguous bits. A common RS encoding scheme uses a codeword of 255 eight-bit symbols, 223 of which are information symbols, and the remaining 32 symbols are error correcting parity symbols. This encoding scheme will correct up to 16 erroneous symbols in every 255-bit codeword, thereby providing a substantial improvement with respect to the 'received' Bit Error Rate.

The RS encoding scheme will also detect 'erasures', which are errors at known locations, and require less information to correct. The number of erasures plus twice the number of errors that an RS decoder can correct is (n-k)/2.

For ease of reference, the term 'error' is used hereinafter to refer to either an error of unknown location or an erasure of known location.

Fig. 1 illustrates an example block diagram of a prior art RS decoder 100. The decoder 100 receives each codeword r(x) 101, and produces a corrected codeword c(x) 151. A syndrome calculator 110 processes the codeword 101 to produce corresponding syndrome polynomials $S_i(x)$ 111. Each codeword has n-k syndromes that depend only on errors, and not on the transmitted codeword. From these syndromes 111, an error locator polynomial $\Delta(x)$ 121 is produced. Euclid's algorithm 120 is illustrated for providing the error locator polynomial 121, and an error magnitude polynomial $\Omega(x)$ 122, although other techniques, such as the Berlekamp-Massey algorithm can be used as well. Each RS code has a parameter '$\alpha$' that is the primitive element of a Galois Field (FG) that is chosen for the RS code. The error locator polynomial is structured such that if an error occurs at position p, $\alpha^{-p}$ will be a root of the error polynomial (p is indexed from 0 to n-1).

An iterative approach is conventionally applied to test each value of $\alpha^{-p}$ for each position p in the codeword, to determine of $\alpha^{-p}$ is a root, $X_k^{-1}$, of the error locator polynomial 121. A commonly used algorithm for this iterative test is the Chien error locator 130. The Chien locator 130 also provides a related error differential term, $X_k^{-1}\,\Delta'(X_k^{-1})$ 132, that facilitates a determination of the magnitude 141 of the error, typically via the Forney error determination algorithm, as illustrated at block 140.

The error determinator 140 evaluates the error magnitude polynomial 122 corresponding to the located error symbol. For each error that the error locator 130 locates, an error corrector 150 determines the corrected codeword c(x) 151, based on the location 131 and magnitude 141 of this error. If an error is not detected for a given symbol, the symbol in the corrected codeword c(x) 151 at this evaluated position is equal to the symbol in the received codeword r(x) 101.

WO-A-01/39378 shows a Reed-Solomon decoder that simultaneously searches for m roots of the error locator polynomial and the error magnitude polynomial. A polynomial evaluator includes a plurality of slice elements corresponding to each term of the polynomial. Each slice element includes a plurality of coefficient multipliers that are configured to evaluate the term for different values, thereby effecting a simultaneous evaluation of the polynomial at each of these different values.

US-B-6 279 137 shows a system and method for a storage-efficient parallel Chien search. The system determines the root of a polynomial by employing a parallel structure that implements a Chien Search and reduces the amount of storage required.

The location of an error in a codeword can be derived from the root of an error locator polynomial. The performance of the Chien Search is enhanced by the parallel structure, and the location of the error can be easily determined using a simple calculation that preferably includes the cycle count, the parallelism, and the index of the multiplier/summer rank that indicates a root. Multiple ranks of multipliers receive data stored in a single array of data storage units. Multiplier values of each multiplier are based on the elements of a Galois Field.

EP-A-1 102 406 shows a decoder circuit used for decoding Reed-Solomon codes. A decoder is provided which performs concurrent execution of a Chien search that determines the error locator polynomial for a received code word and a Forney algorithm that computes the error pattern.

US-B-6 347 389 shows a pipelined Reed-Solomon error/erasure decoder processes multiple code words in a pipelined fashion. The pipelined Reed-Solomon error/erasure decoder is designed to process Reed-Solomon encoded words that have been corrupted in a digital system by processing errors as well as erasures through a simple iterative modified syndrome process.

Invention

The problem to be solved by the invention is to provide an improved Reed-Solomon decoder and an improved method for Reed-Solomon decoding. Further, to provide an improved electronic system including a Reed-Solomon decoder, such as a DVD system.
This problem is solved basically by applying the features of the independent claims. Preferred embodiments of the invention are given in the dependent claims.
In essence, the invention provides for improved Reed-Solomon decoding by combining a parallel Chien search with a modified serial Forney's computation. This enables to reduce the required hardware complexity of the decoder while increasing decoder performance.
In accordance with the invention, the error positions only are calculated in the parallel Chien search block. In a CD or DVD system, the erasure locations need not to be calculated in the Chien search as they are already known from the demodulation block of the CD or DVD system.
Because the erasure locations, which are commonly referred to as 'roots', are known, it is possible to reduce the complexity of the parallel Chien search logic. This implies that the Chien search logic has only to evaluate the error locator polynomial $\Delta(x)$.
The error locations and the roots that correspond to these error locations are known after evaluation of the error locator polynomial. Preferably the roots are stored in a shift register.
The hardware complexity is further reduced by the use of a modified serial Forney's algorithm. The high performance of the combined Chien and Forney's blocks enables to perform multiple-pass error corrections, which essentially decreases the output error rate.
The inventive Reed-Solomon decoder can be utilised in many electronic systems, such as DVD systems or other optical or magnetic storage systems.
In principle, the inventive method is suited for Reed-Solomon decoding and includes the steps of:

- calculating a syndrome polynomial $S(x)$ and an erasure locator polynomial $\Gamma(x)$;
- calculating a modified syndrome polynomial $T(x)=S(x)\Gamma(x) \bmod 2t$, where $t$ is the symbol-error correcting capability of the Reed-Solomon code;
- performing Euclid's algorithm for calculating an error locator polynomial $\Delta(x)$ and an error evaluator polynomial $\Omega(x)$;
- performing a parallel Chien search and concurrently computing an error/erasure locator polynomial $\Psi(x)=\Delta(x)\Gamma(x)$;
- serially computing the error magnitudes according to Forney's equation.

In principle the inventive Reed-Solomon decoder includes:

- means for calculating a syndrome polynomial $S(x)$ and an erasure locator polynomial $\Gamma(x)$;
- means for calculating a modified syndrome polynomial $T(x)=S(x)\Gamma(x) \bmod 2t$, wherein $t$ is the symbol-error correcting capability of the Reed-Solomon code;
- means for performing Euclid's algorithm to calculate an error locator polynomial $\Delta(x)$ and an error evaluator polynomial $\Omega(x)$;
- means for computing an error/erasure locator polynomial $\Psi(x)= \Delta(x)\Gamma(x)$;
- means for performing a parallel Chien search;
- means for serially computing error magnitudes according to Forney's equation.

Advantageous additional embodiments of the invention are disclosed in the respective dependent claims.

Drawings

Exemplary embodiments of the invention are described with reference to the accompanying drawings, which show in:

Fig. 1 example block diagram of a prior art error correcting decoder;
Fig. 2 example block diagram of a parallel Chien search circuit in accordance with the invention;
Fig. 3 example block diagram of a circuit for serial computation of Forney's equation in accordance with the invention.

Exemplary embodiments

The below listed definitions are used:

Error locator polynomial: $\Delta(x)$

Erasure locator polynomial: $\Gamma(x)$

Error / Erasure locator polynomial: $\Psi(x)$

Error position: $i_l,\ldots,i_v$

Error locations: $X_l = a^{i_l}$

Error values: $e_k, 0 <= k < n$

Erasure positions: $j_1,\ldots,j_f$

Erasure locators: $Y_l = a^{j_l}$

Erasure values: $f_k, 0 <= k < n$

The Reed-Solomon decoding can be considered as employing five steps.

Step 1:

Reed-Solomon decoding starts with calculating a syndrome polynomial S(x):

$$S(x) = \sum_{i=1}^{2t} S_i x^i$$

Further an erasure locator polynomial Γ(x) is calculated, where

$$\Gamma(x) = \prod_{i=1}^{p} \left(1 - xa^{j_i}\right)$$

Thereby the erasure locations (roots) are found.

Step 2:

A modified syndrome polynomial T(x) = = S(x)Γ(x) mod 2*t* is calculated, where *t* is the symbol-error correcting capability of the Reed-Solomon code.

Step 3:

Euclid's algorithm is used, which is a method for finding the greatest common divisor of two polynomials, cf. Y.M. Sugiyama, S.H. Kasahara, and T. Namekawa, "A Method for Solving the Key Equation for Decoding of Goppa Codes", Information and Control, Volume 27, pp. 87-89, January 1975.
Both the error locator polynomial Δ(x) and the error evaluator polynomial Ω(x) can be calculated using Euclid's algorithm. This is as such known from the prior art, cf. Steven B. Wicker, Vijay K. Bhargava, "Reed-Solomon codes and their applications", IEEE Press 1994.

Step 4:

Next, the error locations are computed using a parallel Chien block. At the same time a new error/erasure locator polynomial $\Psi(x) = \Delta(x)\Gamma(x)$ is computed to increase the performance of RS decoder. This is a particular advantage of the invention.

Step 5:

The coefficients of a new error/erasure polynomial are loaded into the registers of a serial Forney's block, and the error/erasure magnitude values are computed.

The erasure locations (roots) are already known after carrying out step 1, or are obtained by means of the demodulation block of the CD or DVD system. Therefore the erasure locations need not be calculated in the Chien search of step 5. Advantageously, because the erasure locations are known one can reduce the complexity of the parallel Chien search logic, i.e. the Chien search logic needs to evaluate the error locator polynomial $\Delta(x)$ only. Advantageously, error locator polynomial $\Delta(x)$ has nine coefficients only. The error locations and the roots that correspond to these error locations are known after evaluation of this error locator polynomial.

Fig. 2 illustrates a parallel Chien search logic that comprises four ranks. Each cycle of the Chien search logic will check corresponding four trial roots in parallel:

Rank 0 of the Chien search logic searches for roots in every fourth field element that is defined by a sequence of field elements $\alpha^0$, $\alpha^{-4}$, $\alpha^{-8}$, and so on (i.e. error locations 0, 4, 8, ... in a code word) .
Rank 1 of the Chien search logic searches for roots in every fourth field element that is defined by a sequence of field elements $\alpha^{-3}$, $\alpha^{-7}$, $\alpha^{-11}$, and so on (i.e. error locations 3, 7, 11, ... in a code word) .
Rank 2 of the Chien search logic searches for roots in every fourth field elements that is defined by a sequence of field elements $\alpha^2$, $\alpha^6$, $\alpha^{-10}$, and so on (i.e. error locations 2, 6, 10, ... in a code word) .
Rank 3 of the Chien search logic searches for roots in every fourth field elements that is defined by a sequence of field elements $\alpha^1$, $\alpha^{-5}$, $\alpha^{-9}$, and so on (i.e. error locations 1, 5, 9, ... in a code word) .

The Galois Field counter GFC defines the power of the GF element. During initialisation, the $\alpha^0$ element is loaded into the register. In each cycle (clock CLK) counter GFC is counted down.
If comparator compl indicates zero then the multiplication product in multiplier MUL33 of the current power from counter GFC and the $\alpha^{-1}$ element is the root of the error locator polynomial. If comparator comp2 indicates zero then the multiplication product in multiplier MUL34 of the current power from counter GFC and the $\alpha^{-2}$ element is the root of the error locator polynomial. If comparator comp3 indicates zero then the multiplication product in multiplier MUL35 of the current power from counter GFC and the $\alpha^{-3}$ element is the root of the error locator polynomial. If comparator comp4 indicates zero then counter GFC defines the roots.

The shift register SHR1 (in Fig. 3) is used to memorise the roots that correspond to the erasure or the error location. During Step 1 of the decoding process the roots that correspond to the erasure locations are memorised in the SHR1 registers. The depth of SHR1 register is 16. This is enough for memorising all the errors and erasures that are decoded in a RS codeword of a CD or DVD system.

During Step 3 the error locator polynomial $\Delta(x)$ is computed and its nine coefficients are loaded into the registers REG1 to REG9 of the parallel Chien search block depicted in Fig. 2. These registers are clocked by clock CLK. Their output values are fed within each of the four ranks to a chain of multipliers MUL* and adders ADD*. The output of the rank 3 chain is fed to comparator compl. The output of the rank 2 chain is fed to comparator comp2. The output of the rank 1 chain is fed to comparator comp3. The output of the rank 0 chain is fed to comparator comp4. The output of register REG1 to REG8 is in each case fed via a multiplicator MUL32 to MUL25, respectively, applying in each case a factor $\alpha^{-32}$, $\alpha^{-28}$, $\alpha^{-24}$, $\alpha^{-20}$, ..., $\alpha^{-4}$, respectively.
The error locators are found during the evaluation of the error locator polynomial in the Chien search. The values of the inverse of the error locators are output from MUL33, MUL34, MUL35, and GF counter. These locations of the errors are loaded into the above SHR1 registers.

Fig. 3 illustrates the block for calculating an error and erasure magnitude value at various symbol positions, yielding an error or erasure pattern. This block implements the modified Forney algorithm (serial implementation). The error magnitude values and the erasure magnitude values given by the modified Forney algorithm are

$$e_{i_k} = \frac{\Omega(X_k^{-1})}{X_k^{-1}\psi'(X_k^{-1})} \qquad \text{and} \qquad f_{i_k} = \frac{\Omega(X_k^{-1})}{X_k^{-1}\psi'(Y_k^{-1})}, \tag{1}$$

where $\Omega(X_k^{-1})$ is the error evaluator polynomial $\Omega(x)$ evaluated at $x = X_k^{-1}$ and $\Psi'(X_k^{-1})$ is the formal derivative $\Psi'(x)$ of the error/erasure locator polynomial $\Psi(x)$ evaluated at $x = X_K^{-1}$ or where $\Omega(Y_K^{-1})$ is the error evaluator polynomial $\Omega(x)$ evaluated at $x = Y_K^{-1}$.
The $\Omega(x)$ and $\Psi'(x)$ polynomials are expressed below:

$$\Omega(x) = \Omega_0 + \Omega_1 x + \Omega_2 x^2 + ... + \Omega_{15} x^{15} \tag{2}$$

$$\Psi'(x) = \Psi_1 + \Psi_3 x^2 + \Psi_5 x^4 + ... + \Psi_{15} x^{14} \tag{3}$$

The coefficients of an error evaluator polynomial ($\Omega_0$ to $\Omega_{15}$) are loaded into respective registers REG0 to REG15.
The coefficients Ψ1 to Ψ15 of the first derivation Ψ' (x) of an error/erasure polynomial Ψ(x) are loaded into the respective registers REG16 to REG23. These registers as well as registers REG0 to REG15 are clocked by clock CLK.
Afterwards the root x, which corresponds to an erasure or an error location, is output from register SHR1 and input in the Forney block. In a chain of multipliers MUL0 to MUL13 the degrees $x^1, x^2, x^3, ..., x^{15}$ of x are calculated from x. The coefficients Ω1 to Ω15 are multiplied by the respective degrees $x^1, x^2, x^3, ..., x^{15}$ of the current root x using respective multipliers MUL14 to MUL29. In each cycle the set of 15 products is summed up by respective adders ADD2 to ADD15. Additionally, in ADD 1 the value Ω0 is added to the first product. The output of adder A3D15 is the result of the evaluation of the error evaluator polynomial Ω(x) at a current root $x = X_k^{-1}$.
The coefficients Ψ1, Ψ3, Ψ5, ..., Ψ15 are multiplied with corresponding degrees $x^1, x^3, x^5, ..., x^{15}$ of the current root x by respective multipliers MUL30 to MUL37. In each cycle of clock CLK, the set of products of these multipliers is summed up by respective adders ADD16 to ADD22. The output of ADD22 is the result of the evaluation of the error/erasure polynomial Ψ(x) at the current root $x = X_k^{-1}$.
If in equations (1) a multiplication is used instead of a division they look like

$$e_{i_k} = \Omega(X_k^{-1})(X_k^{-1}\Psi'(X_k^{-1}))^{-1} \qquad f_{i_k} = \Omega(Y_k^{-1})(Y_k^{-1}\Psi'(Y_k^{-1}))^{-1} \tag{4}$$

The product Xk-1 Ψ' (Xk-1) from the output of adder ADD22 is inverted in an GF inverter GFI and multiplied in a multiplier MUL38 with above output value of adder ADD 15, resulting in error magnitude $ei_k$ and erasure magnitude $fi_k$, respectively. The calculated erasure or error magnitude values are output from multiplier MUL38 and stored in a register SHR2. This register has the same depth as register SHR1.
All roots, that have been stored in register SHR1, are processed in the Forney block in the same way. The calculated magnitude values are memorised in register SHR2.
Advantageously, the inventive Chien&Forney stages used for determining error locations and error values in a DVD-system, require the following minimum hardware only:

Chien search block: 36 multipliers, 32 adders, 9 registers, 4 comparators and 1 GF counter.
Forney block: 38 multipliers, 22 adders, 24 registers and 1 GF inverter,

whereas known Chien&Forney stages require the following minimum hardware:

Chien search block: 34 multipliers, 31 adders, 33 registers, 1 comparator, 1 counter and 1 inverter.
Forney block: 136 multipliers, 124 adders, 33 registers, 4 comparators, 4 counters and 4 inverters.

In the invention 67 cycles only for outer code and 62 cycles only for the inner code are required to calculate the error/erasure locations and the error/erasures magnitudes. This is much faster when compared to conventional Chien and Fourney blocks.
The invention can be utilised for any electronic system that requires error determination and/or correction, such as CD, DVD, blue-laser DVD (Blu-Ray) or other storage systems. The invention enables to decrease the number of cycles needed to compute the error locations and the error values and at the same time requires hardware of relatively low complexity only.

## Claims

1. Reed-Solomon decoder including:

- means (110) for calculating a syndrome polynomial $S(x)$ and an erasure locator polynomial $\Gamma(x)$;
- means for calculating a modified syndrome polynomial $T(x)=S(x)\Gamma(x) \bmod 2t$, wherein $t$ is the symbol-error correcting capability of the Reed-Solomon code;
- means (120) for performing Euclid's algorithm to calculate an error locator polynomial $\Delta(x)$ and an error evaluator polynomial $\Omega(x)$;
- means for computing an error/erasure locator polynomial $\Psi(x)= \Delta(x)\Gamma(x)$;
- means (Fig. 2) for performing a parallel Chien search;
- means (Fig. 3) for serially computing error magnitudes according to Forney's equation.

2. Decoder according to claim 1, wherein modified Forney's equations for calculation of error values $e_{i_k}$ and erasure values $f_{i_k}$,

$$e_{i_k} = \frac{\Omega\left(X_k^{-1}\right)}{X_k^{-1}\Psi'\left(X_k^{-1}\right)} \qquad f_{i_k} = \frac{\Omega\left(Y_k^{-1}\right)}{Y_k^{-1}\Psi'\left(Y_k^{-1}\right)}$$

are utilised for the serial computation of the error magnitudes.

3. Decoder according to claim 1, wherein modified Forney's equations for calculation of error values $e_{i_k}$ and erasure values $f_{i_k}$,

$$e_{i_k} = \Omega\left(X_k^{-1}\right)\left(X_k^{-1}\Psi'\left(X_k^{-1}\right)\right)^{-1} \qquad f_{i_k} = \Omega\left(Y_k^{-1}\right)\left(Y_k^{-1}\Psi'\left(Y_k^{-1}\right)\right)^{-1}$$

are utilised for the serial computation of the error magnitudes.

4. Decoder according to claim 1, 2 or 3, said means for performing a parallel Chien search having a number of $n$ ranks for checking $n$ trial roots in parallel.

5. Decoder according to one of claims 1 to 4, said means for serial computation of the error magnitudes according to Forney's equation comprising shift register means (SHR1) for storing the roots determined by said means for performing a parallel Chien search.

6. Decoder according to one of claims 1 to 5, said means for serial computation of the error magnitudes according to Forney's equation comprising Galois Fields inverter means (GFI) for inverting the product $X^{-1}{}_k\Psi'(X^{-1}{}_k)$.

7. Method for Reed-Solomon decoding including the steps of:

- calculating (110) a syndrome polynomial $S(x)$ and an erasure locator polynomial $\Gamma(x)$;

- calculating a modified syndrome polynomial $T(x)=S(x)\Gamma(x) \bmod 2t$, where $t$ is the symbol-error correcting capability of the Reed-Solomon code;

- performing (120) Euclid's algorithm for calculating an error locator polynomial $\Delta(x)$ and an error evaluator polynomial $\Omega(x)$;

- performing (Fig. 2) a parallel Chien search and concurrently computing an error/erasure locator polynomial $\Psi(x)= \Delta(x)\Gamma(x)$;

- serially computing (Fig. 3) the error magnitudes according to Forney's equation.

8. The method of claim 7, wherein modified Forney's equations for calculation of error values $e_{i_k}$ and erasure values $f_{i_k}$,

$$e_{i_k} = \frac{\Omega\left(X_k^{-1}\right)}{X_k^{-1}\Psi'\left(X_k^{-1}\right)} \qquad f_{i_k} = \frac{\Omega\left(\Upsilon_k^{-1}\right)}{\Upsilon_k^{-1}\Psi'\left(\Upsilon_k^{-1}\right)}$$

are utilised for the serial computation of the error magnitudes.

**9.** Method according to claim 7, wherein modified Forney's equations for calculation of error values $e_{i_k}$ and erasure values $f_{i_k}$,

$$e_{i_k} = \Omega\left(X_k^{-1}\right)\left(X_k^{-1}\Psi'\left(X_k^{-1}\right)\right)^{-1} \qquad f_{i_k} = \Omega\left(\Upsilon_k^{-1}\right)\left(\Upsilon_k^{-1}\Psi'\left(\Upsilon_k^{-1}\right)\right)^{-1}$$

are utilised for the serial computation of the error magnitudes.

**10.** Method according to claim 7, 8 or 9, wherein *n* trial roots are checked in parallel by means of *n* ranks.

**11.** Method according to one of claims 7 to 10, wherein said serial computation of the error magnitudes according to Forney's equation is performed by Galois Fields inverter means (GFI) for inverting the product $X_k^{-1}\Psi'(X_k^{-1})$.

**12.** Electronic system, such as a CD, DVD, blue-laser DVD or other optical or magnetic storage system, including a Reed-Solomon decoder in accordance with one of the claims 1 to 6.

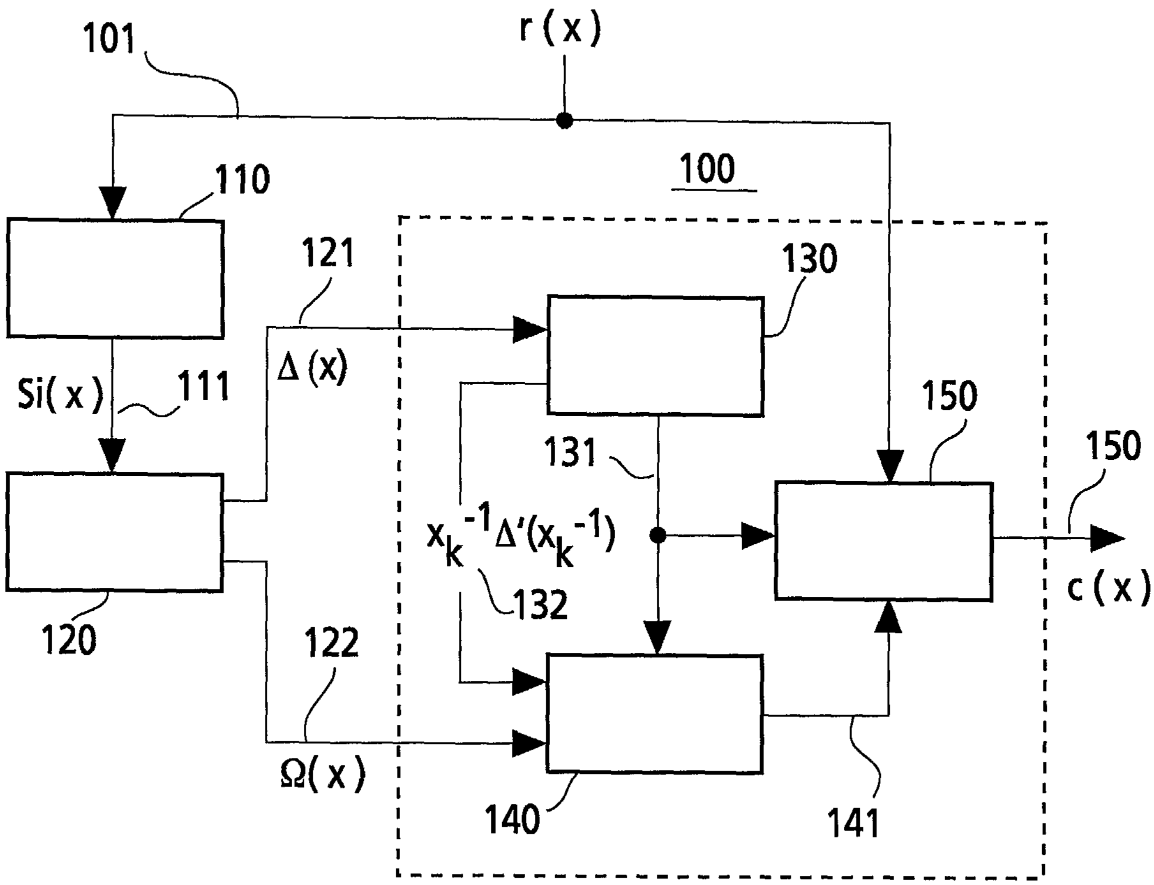
101
r ( x )
100
110
121
130
Si( x )
111
Δ (x)
150
131
150
$x_k^{-1}\Delta'(x_k^{-1})$
132
120
122
c ( x )
Ω( x )
140
141

Fig.1

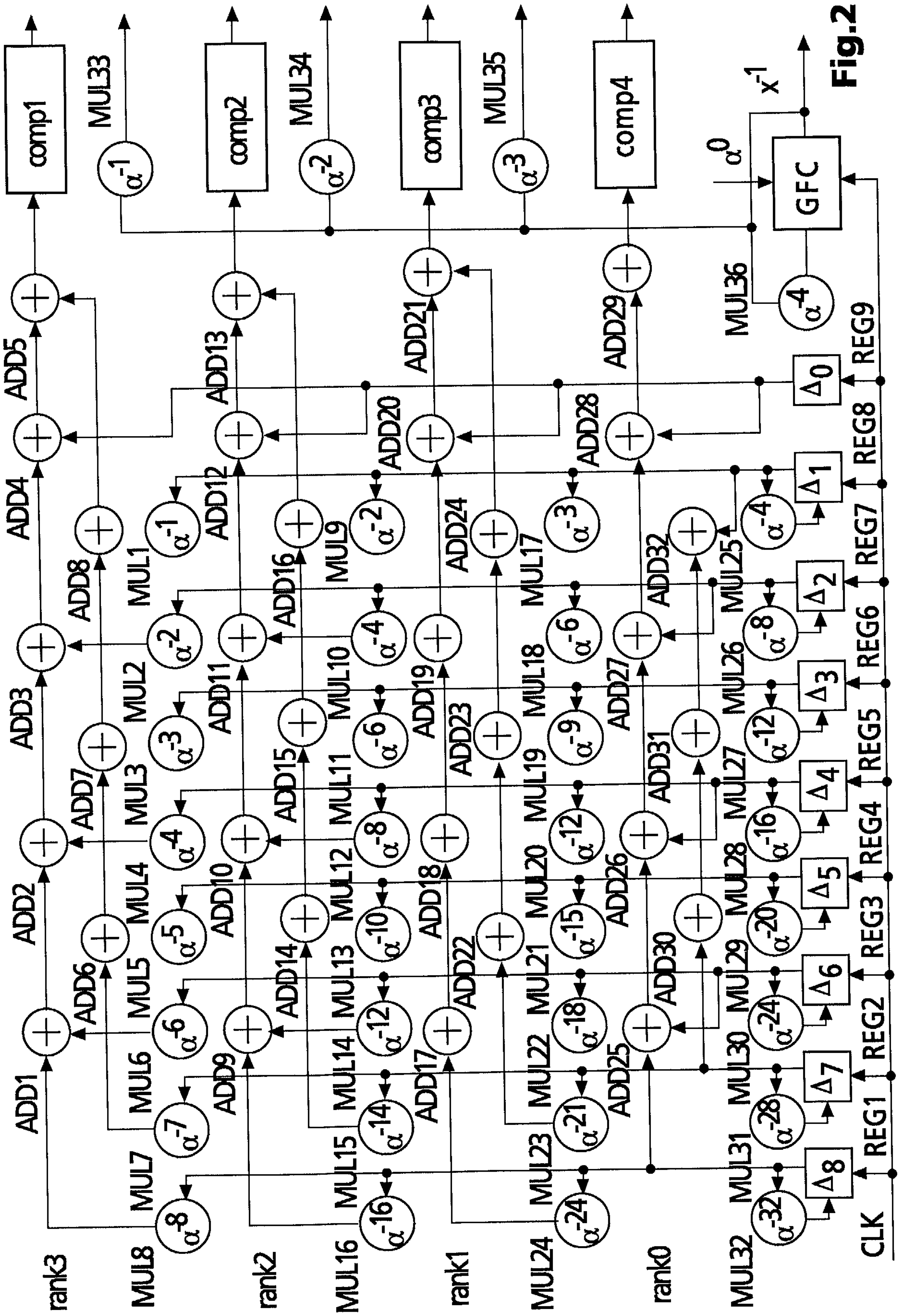
comp1
comp2
comp3
comp4
MUL33
MUL34
MUL35
MUL36
GFC
x^-1
α^0
ADD1
ADD2
ADD3
ADD4
ADD5
ADD6
ADD7
ADD8
ADD9
ADD10
ADD11
ADD12
ADD13
ADD14
ADD15
ADD16
ADD17
ADD18
ADD19
ADD20
ADD21
ADD22
ADD23
ADD24
ADD25
ADD26
ADD27
ADD28
ADD29
ADD30
ADD31
ADD32
MUL1
MUL2
MUL3
MUL4
MUL5
MUL6
MUL7
MUL8
MUL9
MUL10
MUL11
MUL12
MUL13
MUL14
MUL15
MUL16
MUL17
MUL18
MUL19
MUL20
MUL21
MUL22
MUL23
MUL24
MUL25
MUL26
MUL27
MUL28
MUL29
MUL30
MUL31
MUL32
rank3
rank2
rank1
rank0
REG1
REG2
REG3
REG4
REG5
REG6
REG7
REG8
REG9
CLK
Δ0
Δ1
Δ2
Δ3
Δ4
Δ5
Δ6
Δ7
Δ8

Fig.2

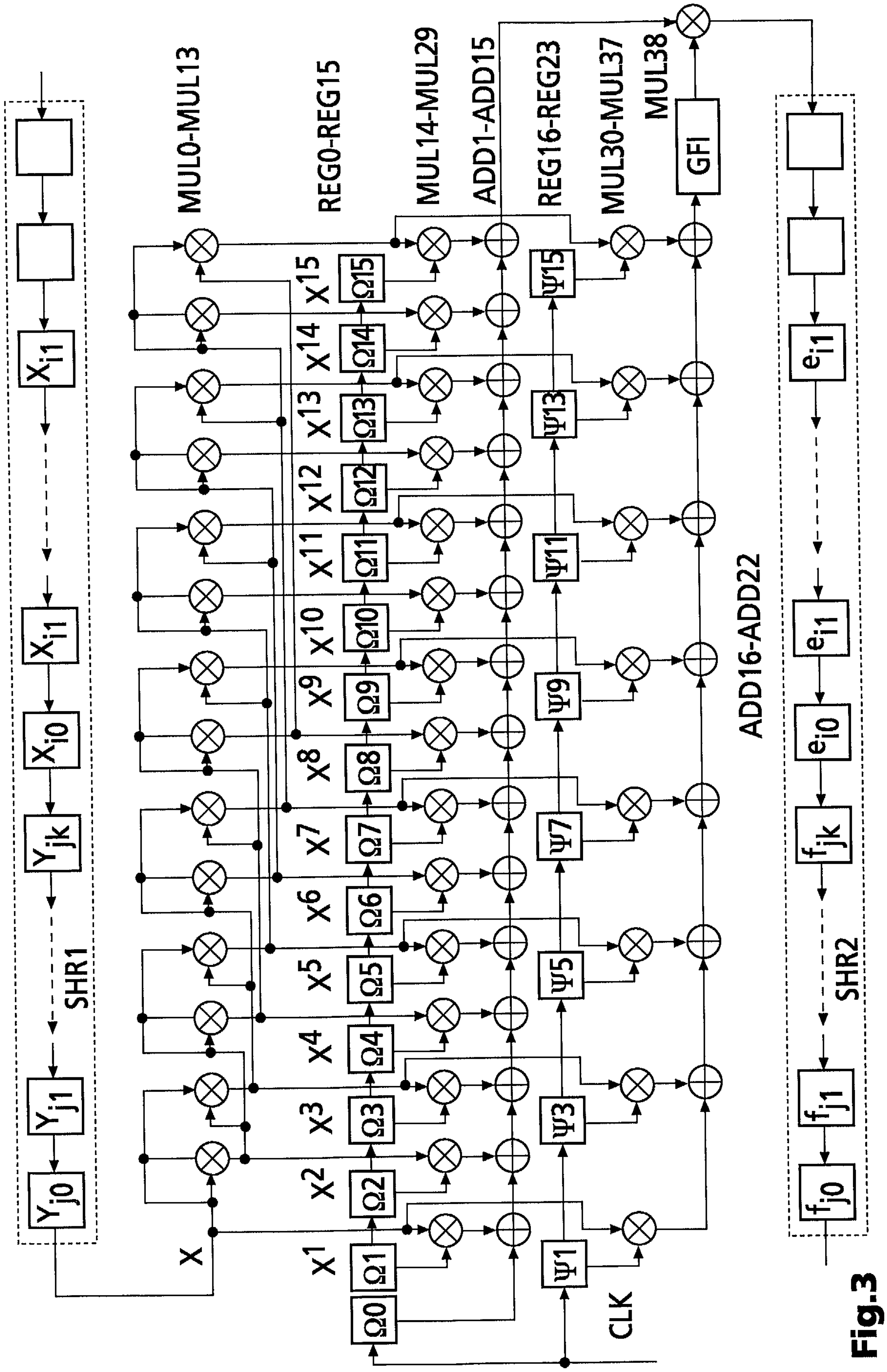
MUL0-MUL13
REG0-REG15
MUL14-MUL29
ADD1-ADD15
REG16-REG23
MUL30-MUL37
MUL38
GFI
ADD16-ADD22
SHR1
SHR2
CLK
X
$X_{i1}$
$X_{i0}$
$Y_{jk}$
$Y_{j1}$
$Y_{j0}$
$e_{i1}$
$e_{i0}$
$f_{jk}$
$f_{j1}$
$f_{j0}$
$X^1$ $X^2$ $X^3$ $X^4$ $X^5$ $X^6$ $X^7$ $X^8$ $X^9$ $X^{10}$ $X^{11}$ $X^{12}$ $X^{13}$ $X^{14}$ $X^{15}$
Ω0 Ω1 Ω2 Ω3 Ω4 Ω5 Ω6 Ω7 Ω8 Ω9 Ω10 Ω11 Ω12 Ω13 Ω14 Ω15
Ψ1 Ψ3 Ψ5 Ψ7 Ψ9 Ψ11 Ψ13 Ψ15

Fig.3

European Patent Office

# EUROPEAN SEARCH REPORT

Application Number
EP 02 09 0207

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | US 5 537 426 A (LEE DONG H) 16 July 1996 (1996-07-16) * the whole document * --- | 1-12 | H03M13/15 |
| D,Y | US 6 279 137 B1 (POEPPELMAN ALAN D ET AL) 21 August 2001 (2001-08-21) * the whole document * --- | 1-12 | |
| D,A | EP 1 102 406 A (ST MICROELECTRONICS INC) 23 May 2001 (2001-05-23) * the whole document * --- | 1-12 | |
| D,A | WO 01 39378 A (KONINKL PHILIPS ELECTRONICS NV) 31 May 2001 (2001-05-31) * the whole document * --- | 1-12 | |
| D,A | US 6 347 389 B1 (BOYER KEITH G) 12 February 2002 (2002-02-12) * the whole document * ----- | 1-12 | |

TECHNICAL FIELDS SEARCHED (Int.Cl.7)

H03M
G11B

The present search report has been drawn up for all claims

| Place of search | Date of completion of the search | Examiner |
|---|---|---|
| THE HAGUE | 12 December 2002 | Barel-Faucheux, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 02 09 0207

This annex lists the patent family members relating to the patent documents cited in the above-mentioned European search report.
The members are as contained in the European Patent Office EDP file on
The European Patent Office is in no way liable for these particulars which are merely given for the purpose of information.

12-12-2002

| Patent document cited in search report | | Publication date | Patent family member(s) | | | Publication date |
|---|---|---|---|---|---|---|
| US 5537426 | A | 16-07-1996 | KR | 9501056 | B1 | 08-02-1995 |
| | | | KR | 9411659 | B1 | 23-12-1994 |
| US 6279137 | B1 | 21-08-2001 | NONE | | | |
| EP 1102406 | A | 23-05-2001 | EP | 1102406 | A2 | 23-05-2001 |
| | | | JP | 2001196938 | A | 19-07-2001 |
| WO 0139378 | A | 31-05-2001 | CN | 1344439 | T | 10-04-2002 |
| | | | WO | 0139378 | A1 | 31-05-2001 |
| | | | EP | 1151542 | A1 | 07-11-2001 |
| US 6347389 | B1 | 12-02-2002 | WO | 0057561 | A1 | 28-09-2000 |

EPO FORM P0459

For more details about this annex : see Official Journal of the European Patent Office, No. 12/82